# EUROPÄISCHE PATENTSCHRIFT

(11) **EP 3 802 910 B1**
(45) Veröffentlichungstag und Bekanntmachung des Hinweises auf die Patenterteilung: **20.07.2022**
(21) Anmeldenummer: 19719252.9
(22) Anmeldetag: 18.04.2019
(51) Int. Cl.: C23C 14/56, C23C 14/50, C23C 14/24, C23C 14/16, B65H 23/032, B65H 23/02, B65H 23/038

(54) **VAKUUMBESCHICHTUNGSANLAGE, UND VERFAHREN ZUM BESCHICHTEN EINES BANDFÖRMIGEN MATERIALS**
VACUUM-COATING SYSTEM AND METHOD FOR COATING A BAND-TYPE MATERIAL
INSTALLATION DE REVÊTEMENT SOUS VIDE ET PROCÉDÉ POUR MUNIR UN MATÉRIAU EN FORME DE BANDE D'UN REVÊTEMENT

(30) Priorität: 28.05.2018 DE 102018208335; 05.09.2018 DE 102018215100
(43) Veröffentlichungstag der Anmeldung: 14.04.2021
(73) Patentinhaber: SMS Group GmbH, 40237 Düsseldorf (DE)
(72) Erfinder: KÜMMEL, Lutz, 41363 Jüchen (DE); DAUBE, Thomas, 47279 Duisburg (DE)
(74) Vertreter: Kross, Ulrich
(86) Internationale Anmeldenummer: PCT/EP2019/060153
(87) Internationale Veröffentlichungsnummer: WO 2019/228708

(56) Entgegenhaltungen:
- EP-A1- 2 463 402
- WO-A1-2017/042614
- DE-A1-102012 108 231
- JP-A- 2008 031 505
- US-A1- 2011 240 225

## Beschreibung

Die Erfindung betrifft eine Vakuumbeschichtungsanlage nach dem Oberbegriff von Anspruch 1 und 3, und ein Verfahren zum Beschichten eines bandförmigen Materials nach dem Oberbegriff von Anspruch 17 und 18.

Bei der Herstellung von Stahlbändern kommt es sowohl beim Warmwalzen als auch beim Kaltwalzen zu Breitenänderungen des Bandes über der Länge. Dies wird durch die sogenannte "Breitung" verursacht, welche eine Zunahme der Breite des gewalzten Bandes von einigen Millimetern durch den Walzstich zur Folge hat. Die unterschiedliche Breitung über der Länge des Stahlbandes ist in der Regel auf Zugschwankungen innerhalb der Anlage, mit der das Stahlband bearbeitet wird, zurückzuführen.

Eine weitere Problematik beim Walzen von Stahlbändern besteht darin, dass durch den Walzprozess Rand- oder Mittelwellen durch unterschiedliche Verlängerung über den Querschnitt entstehen können.

Bei der Herstellung von bandförmigem Material, z.B. in Form von Stahlbändern, ist es nach dem Stand der Technik bekannt, die Oberflächen dieses bandförmigen Materials zu verzinken. Dies kann durch einen Vakuumbedampfungsprozess erfolgen, wie z.B. aus DE 30 35 000 A1, DE 195 27 515 C1 oder DE 197 35 603 C1 bekannt. Zu diesem Vakuumbedampfungsprozess zählt auch die sogenannte PVD- Technologie, die z.B. in der DE 10 2009 053 367 A1 erläutert ist.

Bei dem vorstehend genannten Vakuumbedampfungsprozess erfolgt das Beschichten des bandförmigen Materials in Vakuum, wobei das bandförmige Material durch eine Schleuse und/oder ein System von Blendenelementen einer Kammer oder dergleichen zugeführt wird, in der Vakuum besteht bzw. erzeugt ist. Die Abdichtung des in der Kammer erzeugten Vakuums gegenüber der Umgebung erfolgt in der Regel über Dichtmittel in Form von Blendenelementen, was z.B. in der WO 2008/049523 A1 im Zusammenhang mit einer Bandschleuse beschrieben ist. Eine solche Abdichtung kann gemäß EP 1 004 369 B1 auch durch eine Schleuse mit einer Mehrzahl von Walzen realisiert werden, wobei zumindest eine Walze in Bezug auf mindestens zwei andere Walzen versetzt angeordnet ist und mit ihrer Distanz zu diesen zwei anderen Walzen eingestellt werden kann, um eine Abdichtung für das bandförmige Material, das zwischen diesen Walzen hindurchbewegt wird, zu erreichen. Der Einsatz eines Schleusensystems für einen Transport eines bandförmigen Materials entlang einer horizontalen Transportbahn einer Durchlaufbeschichtungsanlage, bei der innerhalb einer Beschichtungszone ein Beschichten des bandförmigen Materials unter Vakuum erfolgt, ist auch aus DE 10 2012 108 231 A1 bekannt.

Aus JP 2008 031 505 A und US 2011/240225 A1 ist es jeweils bekannt, ein bandförmiges Material mit seiner Breitenerstreckung in senkrechter Ausrichtung durch eine Vakuum-Beschichtungskammer hindurchzuführen. Durch ein Verschwenken bzw. Ansteuern von Walzen, um die herum oder zwischen denen hindurch das bandförmige Material für ein Bewegen in einer Transportrichtung geführt ist, wird erreicht, dass das bandförmige Material eine schräg nach oben gerichtete Kraft erfährt, um ein Durchhängen in Folge seiner Gewichtskraft zu verhindern.

Falls ein bandförmiges Material nach dem Prinzip des Vakuumbedampfungsprozess beschichtet wird, kommt der Abdichtung des Vakuums gegenüber der Umgebung eine große Bedeutung zu. Zu diesem Zweck weist die Vakuumkammer, in der die Beschichtung des bandförmigen Materials realisiert wird, an der Einlassseite und Auslassseite jeweils Schleusen auf. Falls das bandförmige Material über seiner Bandlänge Imperfektionen wie eine nicht konstante Breite (Säbelform) oder Planheitsfehler aufweisen sollte, die durch vorgelagerte Wärmebehandlungprozesse entstehen können, kann es zu einem Verlaufen des bandförmigen Materials auf der Förderstrecke einer Vakuumbeschichtungsanlage kommen, was insbesondere im Bereich der Schleusen einer Vakuumkammer dieser Anlage kritisch ist im Hinblick auf ein notwendiges Abdichten des Vakuums. Eine ungenaue Positionierung des bandförmigen Materials auf der Förderstrecke kann im Bereich der Schleusen der Vakuumkammer entweder zu einem erhöhten Verschleiß oder gar zu einem Einbruch des Vakuums führen, wodurch der Beschichtungsprozess unter Vakuum gestört wird. Hinzu tritt, dass solche Imperfektionen innerhalb der Vakuumkammer zu veränderten Abständen zwischen den Oberflächen des zu beschichtenden bandförmigen Materials und den Beschichtungs- und Reinigungsmodulen führt, wodurch der Vakuum-Beschichtungsprozess ebenfalls beeinträchtigt wird.

Entsprechend liegt der Erfindung die Aufgabe zugrunde, das Beschichten von bandförmigem Material unter Vakuum mit einfachen Mitteln zu optimieren und hierfür eine verbesserte Prozesssicherheit zu erreichen.

Diese Aufgabe wird durch eine Vakuumbeschichtungsanlage gemäß der Ansprüche 1 und 3, und durch ein Verfahren mit den in den Ansprüchen 17 und 18 angegebenen Merkmalen gelöst. Vorteilhafte Weiterbildungen der Erfindung sind in den abhängigen Ansprüchen definiert.

Eine Vakuumbeschichtungsanlage nach der vorliegenden Erfindung dient zum Beschichten eines bandförmigen Materials insbesondere aus Metall, und umfasst eine Förderstrecke mit Transportmitteln insbesondere in Form von Walzen, auf denen das bandförmige Material in einer Transportrichtung bewegt werden kann, eine Beschichtungskammer, in der Vakuum erzeugbar ist, wobei die Beschichtungskammer einen Einlassbereich und einen Auslassbereich aufweist und dadurch von dem bandförmigen Material entlang bzw. auf der Förderstrecke in der Transportrichtung durchlaufen werden kann, eine Einlaufschleuse, die im Einlassbereich der Beschichtungskammer vorgesehen ist, und eine Auslaufschleuse, die im Auslassbereich der Beschichtungskammer vorgesehen ist.

Die Vakuumbeschichtungsanlage umfasst auch zumindest eine Bandlagenregeleinrichtung, mit der eine Position des bandförmigen Materials in Bezug auf eine Mitte der Förderstrecke ausgerichtet werden kann. Eine solche Bandlagenregeleinrichtung ist entweder innerhalb der Beschichtungskammer und/oder - in Transportrichtung des bandförmigen Materials gesehen - stromaufwärts der Beschichtungskammer und außerhalb davon angeordnet ist.

In gleicher Weise sieht die Erfindung auch ein Verfahren zum Beschichten eines bandförmigen Materials insbesondere aus Metall vor, bei dem das bandförmige Material über eine Förderstrecke in einer Transportrichtung bewegt und innerhalb einer Beschichtungskammer, in der ein Vakuum angelegt ist, vakuumbeschichtet wird. Hierbei wird das bandförmige Material durch zumindest eine Bandlagenregeleinrichtung, die entweder innerhalb der Beschichtungskammer und/oder - in Transportrichtung des bandförmigen Materials gesehen - stromaufwärts der Beschichtungskammer und außerhalb davon angeordnet ist, mit seiner Bandmitte in Bezug auf eine Mitte der Förderstrecke ausgerichtet.

Der Erfindung liegt die wesentliche Erkenntnis zugrunde, dass das bandförmige Material durch die Bandlagenregeleinrichtung in Bezug auf eine Mitte der Förderstrecke, d.h. senkrecht zu seiner Transportrichtung, ausgerichtet wird. Hierdurch ist gewährleistet, dass das bandförmige Material insbesondere innerhalb der Beschichtungskammer optimal zentriert auf der Förderstrecke bewegt wird, so dass innerhalb der Beschichtungskammer eine Kollision bzw. Berührung des bandförmigen Materials mit den Seitenwänden verhindert und ein optimales Beschichtungsergebnis erzielt wird. Hierzu ist es zweckmäßig, wenn eine solche Bandlagenregeleinrichtung in die Beschichtungskammer integriert ist, d.h. innerhalb der Beschichtungskammer angeordnet ist. Falls das bandförmige Material bei seiner Bewegung durch die Beschichtungskammer hindurch in seiner Position von der Förderstrecke zur Seite abweichen bzw. "wegwandern" sollte, kann dem mit der innerhalb der Beschichtungskammer angeordneten Bandlagenregeleinrichtung wirkungsvoll entgegengewirkt werden.

Ergänzend und/oder alternativ ist es auch möglich, dass eine Bandlagenregeleinrichtung - in Transportrichtung des bandförmigen Materials gesehen - stromaufwärts der Beschichtungskammer angeordnet ist. Die Funktionsweise einer solchen außerhalb der Beschichtungskammer angeordneten Bandlagenregeleinrichtung entspricht identisch einer Bandlagenregeleinrichtung, die wie vorstehend erläutert innerhalb der Beschichtungskammer angeordnet ist, nämlich dass hiermit die Position des bandförmigen Materials in Bezug auf eine Mitte der Förderstrecke ausgerichtet wird. Dies führt zu dem Vorteil, dass das bandförmige Material in Bezug auf seine Position auf der Förderstrecke bereits korrekt ausgerichtet ist, wenn es bei seiner Bewegung in der Transportrichtung dann die Einlaufschleuse der Beschichtungskammer erreicht und darin einläuft. Hiermit wird ein störungs- und im Wesentlichen verschleissfreier Kontakt des bandförmigen Materials mit an der Einlaufschleuse vorgesehenen Dichtmitteln erreicht, wodurch ein zuverlässiges Abdichten des Vakuums innerhalb der Beschichtungskammer gegenüber der Umgebung gewährleistet ist.

In vorteilhafter Weiterbildung der Erfindung kann eine Bandlagenregeleinrichtung - in Transportrichtung des bandförmigen Materials gesehen - auch stromaufwärts der Beschichtungskammer angeordnet sein. Somit wird das bandförmige Material, nachdem es beschichtet worden ist, nochmals hinsichtlich einer korrekten Position in Bezug auf eine Mitte der Förderstrecke überprüft und ggf. hierzu korrigierend ausgerichtet. Damit ist gewährleistet, dass das beschichtete bandförmige Material störungsfrei auf einer Haspeleinrichtung aufgewickelt oder ggf. in einem davor angeordneten Speicher zwischengespeichert werden kann.

In vorteilhafter Weiterbildung der Erfindung sind eine Steuerungseinrichtung und zumindest ein Positionssensor vorgesehen, wobei zwischen einer Bandlagenregeleinrichtung und einem solchen Positionssensor eine Signalverbindung mit dieser Steuerungseinrichtung besteht. Mit dem Positionssensor kann eine Position des bandförmigen Materials auf der Förderstrecke erkannt bzw. bestimmt werden, insbesondere in Bezug auf einen Mittenbereich der Förderstrecke. Falls dabei eine Abweichung der Position des bandförmigen Materials bezüglich des Mittenbereichs der Förderstrecke erkannt werden sollte, kann eine Bandlagenregeleinrichtung in Abhängigkeit der Signale des Positionssensors durch die Steuerungseinrichtung geeignet angesteuert werden, zwecks einer Korrektur bzw. Ausrichtung der Position des bandförmigen Materials auf der Förderstrecke.

Mit der vorliegenden Erfindung lässt sich vorteilhaft eine Beschichtung von bandförmigem Material unter Vakuum realisieren, das aus Stahlband besteht und einen Gefügeanteil von mindestens 10% Martensit aufweist. Ein solches Stahlband kann weiterhin 0,1 - 0,4% Kohlenstoff, 0,5 - 2,0 % Silizium und/oder 1,5-3,0% Mangan enthalten. Solche Stähle können als "Dualphasenstähle" (DP), "Komplexphasenstahl" (CP), "Quenching and Partitioning Stähle" (Q&P) oder als "Martensitische Stähle" (MS) vorliegen, die jeweils einen unterschiedlichen Gehalt an Martensiten (mit zumindest 10%) haben.

Nachstehend ist eine bevorzugte Ausführungsform der Erfindung anhand einer schematisch vereinfachten Zeichnung im Detail beschrieben. Es zeigen:
- Fig. 1: eine schematisch vereinfachte Seitenansicht einer erfindungsgemäßen Vakuumbeschichtungsanlage, mit der auch ein Verfahren nach der vorliegenden Erfindung durchgeführt werden kann,
- Fig. 2-4: jeweils schematisch vereinfachte Ansichten von verschiedenen Ausführungsformen einer Bandlagenregeleinrichtung, die bei einer Vakuumbeschichtungsanlage von Fig. 1 zum Einsatz kommt, und
- Fig. 5, Fig. 6: jeweils vereinfachte Draufsicht auf eine Steuerrolle nach weiteren Ausführungsformen der Erfindung.

Die vorliegende Erfindung sieht eine Vakuumbeschichtungsanlage 10 vor, mit der ein bandförmiges Material 11 an zumindest einer Seite davon, vorzugsweise an beiden Seiten (Oberseite und Unterseite) mit einer Beschichtung versehen werden kann. Entsprechend kann mit einer solchen Vakuumbeschichtungsanlage 10 auch ein Verfahren durchgeführt werden, um das bandförmige Material 11 insbesondere zu beschichten. Gleiche Merkmale in den beiden Figuren der Zeichnung sind jeweils mit gleichen Bezugszeichen versehen. An dieser Stelle wird gesondert darauf hingewiesen, dass die Zeichnung lediglich vereinfacht und insbesondere ohne Maßstab dargestellt ist.

Das bandförmige Material 11 kann aus Metall bestehen, insbesondere aus Stahl oder Edelstahl oder entsprechenden Legierungen hiervon. Des Weiteren wird darauf hingewiesen, dass es sich bei dem bandförmigen Material 11, welches mit der Vakuumbeschichtungsanlage 10 beschichtet wird, um Warmband oder Kaltband handeln kann.

Nachfolgend sind die Vakuumbeschichtungsanlage 10, die einzelnen Komponenten hiervon und deren Funktionsweise im Detail erläutert:
Die Vakuumbeschichtungsanlage 10 umfasst eine Förderstrecke 12 mit (nicht gezeigten) Transportmitteln, z.B. in Form von Walzen, auf denen das bandförmige Material in einer Transportrichtung T bewegt wird. Hierbei wird das bandförmige Material 11 am Einlauf der Förderstrecke 12 von einer ersten Haspeleinrichtung 46 abgewickelt, wobei das bandförmige Material 11 - nach Durchführung bzw. Abschluss der gewünschten Beschichtung - am Auslauf der Förderstrecke 12 von einer zweiten Haspeleinrichtung 48 wieder aufgewickelt wird. Direkt nach der ersten Haspeleinrichtung 46 und vor der zweiten Haspeleinrichtung 48 können (Band-)Speicher 44 vorgesehen sein, mit bzw. in denen das bandförmige Material 11 gespeichert werden kann. Innerhalb der Förderstrecke 12 wird das bandförmige Material 11 in der Bewegungsrichtung T bewegt bzw. transportiert, nämlich von der ersten Haspeleinrichtung 46 in Richtung der zweiten Haspeleinrichtung 48.

Entlang der Förderstrecke 12 ist eine Beschichtungskammer 14 angeordnet, durch die hindurch das bandförmige Material 11 bewegt wird. Zu diesem Zweck weist die Beschichtungskammer 14 einen Einlassbereich 16 und einen Auslassbereich 18 auf, wobei in dem Einlassbereich 16 eine Einlaufschleuse 20 und in dem Auslaufbereich 18 eine Auslaufschleuse 22 vorgesehen sind. In der Beschichtungskammer 14 wird Vakuum erzeugt. Hierbei gewährleisten die Einlaufschleuse 20 und die Auslaufschleuse 22 eine geeignete Abdichtung dieses Vakuums gegenüber der äußeren Umgebung, bei gleichzeitiger Bewegung des bandförmigen Materials 11 entlang der Förderstrecke 12 bzw. durch diese beiden Schleusen 20, 22 hindurch.

Die Beschichtungskammer 14 ist mehrteilig ausgebildet und weist einen Beschichtungsteil 26 und einen Reinigungsteil 28 auf. Beide dieser Teile 26 und 28 sind - wie vorstehend bereits erläutert - unter Vakuum gesetzt. In dem Beschichtungsteil 26 wird das eigentliche Beschichten des bandförmigen Materials 11 durchgeführt, z.B. nach dem Prinzip der "PVD" (= *physical vapor deposition),* an entweder einer Seite des bandförmigen Materials oder an beiden Seiten hiervon.

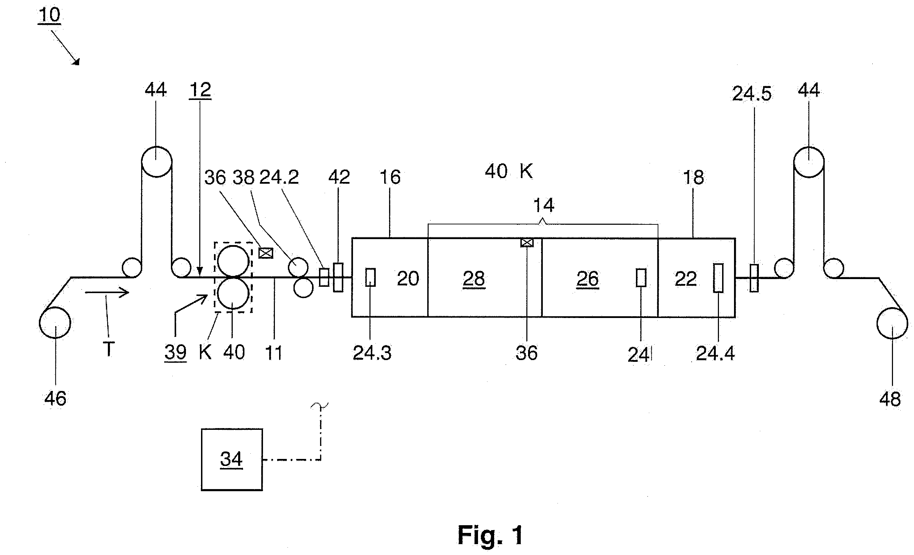

Innerhalb der Beschichtungskammer 14 kann zumindest eine Bandlagenregeleinrichtung 24 angeordnet sein, z.B. innerhalb des Beschichtungsteil 26, wie in der Fig. 1 gezeigt. Ergänzend oder alternativ ist es möglich, eine solche Bandlagenregeleinrichtung 24 in dem Reinigungsteil 28 anzuordnen.

Nach einer weiteren Ausführungsform der Erfindung ist es möglich, eine Bandlagenregeleinrichtung 24.2 - in Transportrichtung T des bandförmigen Materials 11 gesehen - stromaufwärts der Einlaufschleuse 20 anzuordnen. Diesbezüglich wird darauf hingewiesen, dass auch eine Kombination mit der zuvor genannten Ausführungsform möglich ist, wobei dann sowohl eine Bandlagenregeleinrichtung 24 innerhalb der Beschichtungskammer 14 als auch eine Bandlagenregeleinrichtung 24.2 in dem Bereich stromaufwärts der Einlaufschleuse 20 angeordnet ist.

Optional kann auch vorgesehen sein, dass eine Bandlagenregeleinrichtung 24.3 auch im Bereich der Einlaufschleuse 20, und eine weitere Bandlagenregeleinrichtung 24.4 im Bereich der Auslaufschleuse 22 vorgesehen sind. Schließlich ist es auch möglich, eine weitere Bandlagenregeleinrichtung 24.5 - in Transportrichtung T des bandförmigen Materials 11 gesehen - stromaufwärts der Auslaufschleuse 22 anzuordnen.

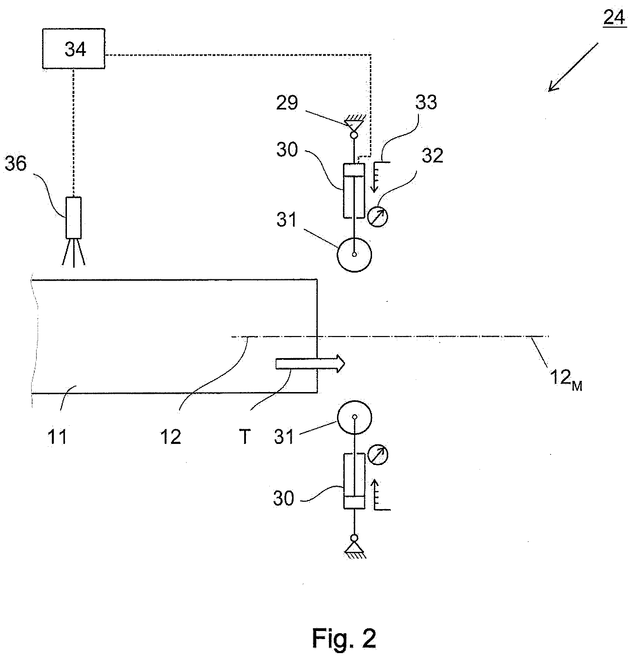

Unter Bezugnahme auf die nachfolgenden Fig. 2 bis 6 sind verschiedene Ausführungsformen einer Bandlagenregeleinrichtung 24 (bzw. 24.2, 24.3, 24.4, 24.5) und deren Funktionsweise im Detail erläutert.

Fig. 2 zeigt vereinfacht die wesentlichen Komponenten einer Ausführungsform der Bandlagenregeleinrichtung 24 in Verbindung mit einer Draufsicht auf das bandförmige Material 11, wobei die übrigen Teile der Vakuumbeschichtungsanlage 10 von Fig. 1 zur Vereinfachung weggelassen sind. In der Fig. 2 ist die Förderstrecke 12 vereinfacht durch eine strichpunktierte Linie symbolisiert, wobei eine Mitte dieser Förderstrecke mit "12_{M}" bezeichnet ist. An einem Lager 29 bzw. Teil eines Gehäuses der Beschichtungskammer 14 ist ein Stellglied 30 angebracht, an dessen vorderem Ende eine Kontaktrolle 31 drehbar gelagert ist. Das Stellglied 30 ist in Form eines Hydraulikzylinders ausgebildet, wobei alternativ hierzu - mit gleicher Funktionalität - auch ein Stellglied in Form eines elektrischen Linearmotors oder dergleichen möglich ist. Mittels des Stellglieds 30 ist eine Bewegung der Kontaktrolle 31 in Richtung des bandförmigen Materials 1 senkrecht zu dessen Transportrichtung T möglich.

Die Position des bandförmigen Materials 11 auf der Förderstrecke 12 kann durch einen Positionssensor 36 erfasst werden, der signaltechnisch mit einer Steuerungseinrichtung 34 verbunden ist (in Fig. 2 symbolisch durch eine gestrichelte hier gezeigt). Insoweit kommt dem Positionssensor 36 die Funktion eines Bandlagenerfassungselements zu. Ein solcher Positionssensor 36 kann vorzugsweise als Abstandsmesser oder dergleichen ausgebildet sein, z.B. in Form eines Lasersensors.

Die Ansteuerung eines Stellglieds 30 kann kraftgesteuert und/oder weggesteuert erfolgen. Hierzu sind pro Stellglied 30 ein Druckgeber 32 und ein Weggeber 33 vorgesehen. Das Stellglied ist ebenfalls signaltechnisch mit der Steuerungseinrichtung 34 verbunden. Entsprechend kann die Ansteuerung des Stellglieds 30 durch die Steuerungseinrichtung 34 in Abhängigkeit der Signale des Positionssensors 36 erfolgen.

Die Draufsicht von Fig. 2 verdeutlicht, dass ein Stellglied 30 mit einer daran angebrachten Kontaktrolle 31 beiderseits der Förderstrecke 12 angeordnet ist.

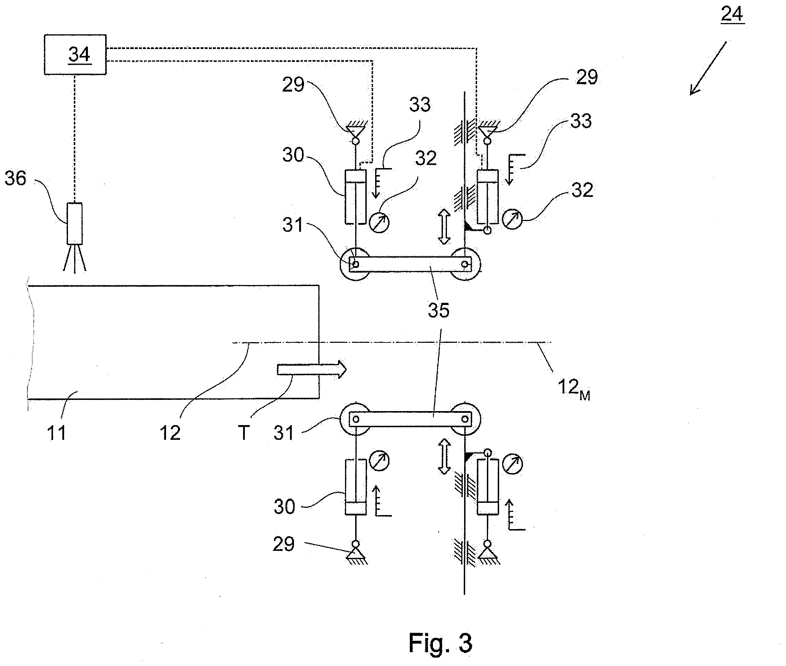

Die Fig. 3 zeigt eine weitere Ausführungsform für die Bandlagenregeleinrichtung 24. Im Unterschied zur Ausführungsform von Fig. 2 sind hierbei an jeder Seite der Förderstrecke 12 zwei Kontaktrollen 31 vorgesehen, die an einem Führungslineal 35 drehbar angebracht sind. Pro Führungslineal 35 sind zwei Stellglieder 30 vorgesehen, z.B. in Form von Hydraulikzylindern, die signaltechnisch mit der Steuerungseinrichtung 34 verbunden und dadurch, in Abhängigkeit der Signale des Positionssensors 36, kraftgesteuert und/oder weggesteuert werden können.

Bei den Ausführungsformen nach den Fig. 2 und 3 dienen die Kontaktrollen 31 dazu, bei Bedarf - durch entsprechende Betätigung der Stellglieder 30 - senkrecht zur Transportrichtung T an die Bandkanten des bandförmigen Materials 11 angestellt zu werden und damit in Kontakt zu gelangen, um eine Position des bandförmigen Materials 11 in Bezug auf die Mitte 12_{M} der Förderstrecke 12 zu korrigieren bzw. darauf auszurichten.

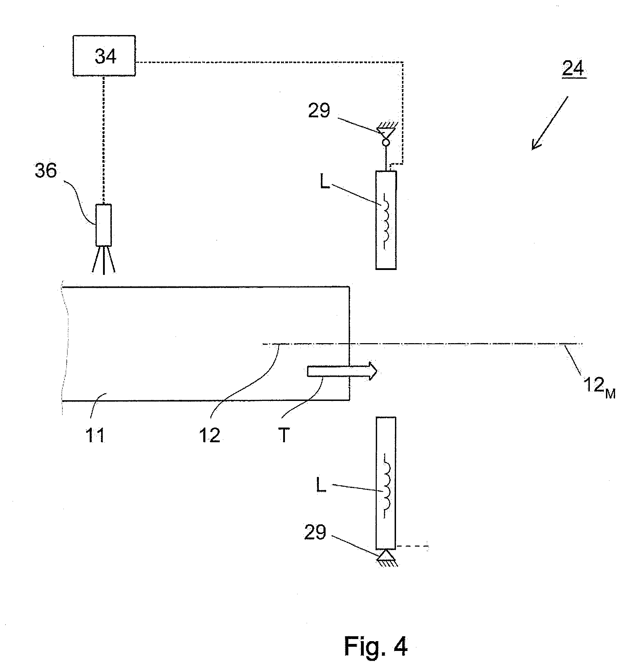

Die Fig. 4 zeigt eine weitere Ausführungsform für die Bandlagenregeleinrichtung 24, bei der beiderseits der Förderstrecke 12 jeweils eine bestrombare Spule L vorgesehen ist, die an einem Lager 29 bzw. Gehäuseteil der Beschichtungskammer 14 angebracht ist. Diese Spulen L sind signaltechnisch mit der Steuerungseinrichtung 34 verbunden, so dass sie in Abhängigkeit von Signalen des Positionssensors 36 angesteuert bzw. bestromt werden können. Durch die Bestromung dieser Spulen L wird angrenzend an die Förderstrecke 12 ein Magnetfeld bzw. ein elektromagnetisches Wechselfeld erzeugt, das mit dem bandförmigen Material 11 insbesondere dann in Wechselwirkung gelangt, wenn es aus Stahl oder einer Stahllegierung besteht. Konkret bedeutet dies, dass durch diese Wechselwirkung eine Abstoßung zwischen den bestromten Spulen L und dem bandförmigen Material 11 bestehend aus Stahl hervorgerufen wird. Durch diese Wechselwirkung bzw. Abstoßung kann in gleicher Weise wie mit den Kontaktrollen 31 erreicht werden, eine Position des bandförmigen Materials 11 in Bezug auf die Mitte 12_{M} der Förderstrecke 12 zu korrigieren bzw. darauf auszurichten.

Die vorstehend erläuterten Ausführungsformen einer Bandlagenregeleinrichtung 24 nach den Fig. 2-4 funktionieren nun wie folgt:
In einem Ausgangszustand befinden sich bei den Ausführungsformen von Fig. 2 und Fig. 3 die Kontaktrollen 31 nicht in Kontakt mit den Bandkanten des bandförmigen Materials 11. In gleicher Weise sind bei der Ausführungsform von Fig. 4 die Spulen L stromlos gestellt, so dass auf das bandförmige Material 11 kein Magnetfeld einwirkt.

Falls nun im Betrieb der Vakuumbeschichtungsanlage 10 und einer Bewegung des bandförmigen Materials 11 entlang der Förderstrecke 12 durch den Positionssensor 36 festgestellt werden sollte, dass das bandförmige Material 11 über seiner Breite, d.h. senkrecht zur Transportrichtung T, Unregelmäßigkeiten aufweist und/oder sich nicht exakt auf der Mitte 12_{M} der Förderstrecke 12 läuft, werden mittels der Steuerungseinrichtung 34 die Stellglieder 30 aktuiert bzw. die Spulen L bestromt, so dass durch das Anstellen der Kontaktrollen 31 an die Bandkanten des bandförmigen Materials 11 bzw. durch die Wechselwirkung der erzeugten Magnetfelder mit dem Band bestehend aus Stahl eine Position des bandförmigen Materials 11 auf der Förderstrecke 12 geeignet korrigiert wird. In Folge dessen wird der Bandlauf des bandförmigen Materials 11 auf der Förderstrecke 12 senkrecht bzw. quer zur Transportrichtung T korrigiert. In diesem Zusammenhang wird darauf hingewiesen, dass die Kontaktrollen 31 nur solange in Kontakt mit den Bandkanten bzw. Seitenrändern des bandförmigen Materials 11 sind, wie es für eine Korrektur der Position des bandförmigen Materials 11 auf der Förderstrecke 12 in Bezug auf deren Mitte 12_{M} erforderlich ist. Anders ausgedrückt, können die Kontaktrollen 31 durch eine Betätigung der Stellglieder 30 wieder von den Bandkanten des bandförmigen Materials 11 abgerückt bzw. davon senkrecht zur Transportrichtung T wegbewegt werden, wenn durch den Positionssensor 36 eine korrekte Position des bandförmigen Materials 11 auf der Förderstrecke 12 erkannt wird. Mutatis mutandis gilt dies auch für die Spulen L bei der Ausführungsform von Fig. 4, die nur solange bestromt werden, wie es für eine Positionskorrektur des bandförmigen Materials 11 erforderlich ist.

Je nach Anordnung einer Bandlagenregeleinrichtung 24 kann ein Positionssensor 36 innerhalb der Beschichtungskammer 14 angeordnet sein, oder auch in einem Bereich stromaufwärts der Einlaufschleuse 20 oder stromabwärts der Auslaufschleuse 22, oder auch im Bereich der Einlaufschleuse 20 bzw. der Auslaufschleuse 22. Dies bedeutet, dass die Vakuumbeschichtungsanlage 10 mehrere solcher Positionssensoren 36 umfassen kann, die einer jeweiligen Bandlagenregeleinrichtung in den verschiedenen Bereichen der Vakuumbeschichtungsanlage 10 zugeordnet sind.

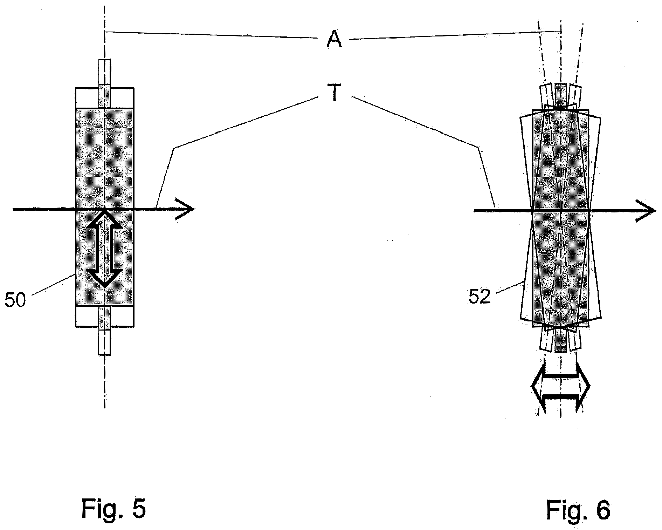

Nach weiteren Ausführungsformen der Bandlagenregeleinrichtung 24 kann hierbei eine sogenannte Steuerrolle (oder eine Mehrzahl von solchen Steuerrollen) eingesetzt werden, die in der Fig. 5 und in der Fig. 6 in einer vereinfachten Draufsicht gezeigt sind und z.B. von der EMG Automation GmbH (D-57482 Wenden) angeboten werden. Hierbei wird das bandförmige Material 11 über eine Steuerrolle geführt, wobei sich zwischen dem bandförmigen Material 11 und der Steuerrolle ein bestimmter Umschlingungswinkel einstellt.

In den Darstellungen von Fig. 5 und Fig. 6 ist die Transportrichtung, mit der das bandförmige Material 11 über die Steuerrolle geführt wird, ebenfalls mit "T" bezeichnet, wobei zur Vereinfachung das bandförmige Material selber nicht gezeigt ist. Bei der Steuerrolle 50 gemäß Fig. 5 erfolgt deren Verstellung relativ zum bandförmigen Material 11 derart, dass die Steuerrolle 50 entlang ihrer Längsachse A senkrecht zur Transportrichtung T verschoben wird. In dieser Weise wirkt die Steuerrolle 50 proportional. Demgegenüber erfolgt eine Verstellung der Steuerrolle 52 gemäß Fig. 6 derart, dass die Steuerrolle 52 mit ihrer Längsachse A relativ zur Transportrichtung T verdreht wird, wie dies in der Fig. 6 ausgehend von einer Position, bei der die Längsachse A mit der Transportrichtung T ein Winkel von 90° einschließt, für zwei beispielhafte Auslenkungen bzw. verdrehte Positionen gezeigt ist. In dieser Weise wirkt die Steuerrolle 52 integral.

In Bezug auf die Steuerrollen 50, 52, die in den Fig. 5 und 6 veranschaulicht und erläutert sind, darf darauf hingewiesen werden, dass es bei einer weiteren (nicht gezeigten) Ausführungsform der Bandlagenregeleinrichtung 24 möglich ist, die Funktionen der Steuerrollen 50, 52 und deren Verstellmöglichkeit in Form einer sogenannten Hebelsteuerrolle miteinander zu kombinieren.

Durch den Einsatz von zumindest einer Bandlagenregeleinrichtung, wie vorstehend erläutert, wird erreicht, dass das bandförmige Material 11 innerhalb der unter Vakuum gesetzten Beschichtungskammer 14 stets optimal positioniert auf der Förderstrecke 12 entlang der Transportrichtung T bewegt wird, so dass z.B. ein "Anecken" bzw. eine Berührung des bandförmigen Materials 11 mit Seitenwänden der Beschichtungskammer 14 bzw. des Beschichtungsteil 26 verhindert wird. Gleiches gilt für den Einlauf des bandförmigen Materials 11 in die Einlaufschleuse 20, oder auch für ein weiteres Bewegen des bandförmigen Materials 11 auf der Transportstrecke 12 nach dem Austritt aus der Auslaufschleuse 22.

In Transportrichtung T des bandförmigen Materials 11 gesehen kann stromaufwärts der Einlaufschleuse 20 eine weitere chemische Reinigungseinrichtung 42 angeordnet sein, die von dem bandförmigen Material 11 vor einem Einlaufen in die Beschichtungskammer 14 durchlaufen wird. Hierdurch werden die Oberflächen des bandförmigen Materials 11, bevor es in dem Reinigungsteil 28 (unter Vakuum) einer Feinreinigung unterzogen wird, vorbereitend gesäubert bzw. gereinigt.

Die Vakuumbeschichtungsanlage 10 umfasst zumindest eine Planheitsoptimierungseinrichtung 39, die eine Dressiergerüsteinrichtung 40 aufweist und - in Transportrichtung T des bandförmigen Materials 11 gesehen - stromaufwärts der Einlaufschleuse 20 angeordnet ist. Das bandförmige Material 11 durchläuft die Dressiergerüsteinrichtung 40, bevor es anschließend in die Beschichtungskammer 14 einläuft. Durch den Kontakt mit den Walzen der Dressiergerüsteinrichtung 40 wird die Planheit an den Oberflächen des bandförmigen Materials 11 auf einen gewünschten Wert eingestellt, wobei gleichzeitig mögliche Planheitsfehler an den Oberflächen des bandförmigen Materials 11 eliminiert werden.

Die Vakuumbeschichtungsanlage 10 umfasst zumindest eine Besäumschere 38, in Transportrichtung T des bandförmigen Materials 11 gesehen stromaufwärts der Einlaufschleuse 20 der Beschichtungskammer 14. Angrenzend hierzu ist zumindest ein weiterer Positionssensor 36 vorgesehen, mit dem eine Position des bandförmigen Materials 11 auf der Förderstrecke 12 in einem Bereich stromaufwärts der Beschichtungskammer 14, und damit auch im Bereich der Besäumschere 38, bestimmt werden kann. Dieser Positionssensor 36 ist ebenfalls mit der Steuerungseinrichtung 34 signaltechnisch verbunden. Entsprechend ist es mittels der Steuerungseinrichtung 34 möglich, die Besäumschere 38 in Abhängigkeit von Signalen des Positionssensors 36 zu betätigen bzw. in Aktion zu setzen.

Die signaltechnische Verbindung zwischen der Steuerungseinrichtung 34 einerseits, und den Positionssensoren 36, den Bandlagenregeleinrichtungen 24 und der Besäumschere 38 andererseits, ist in der Fig. 1 vereinfacht durch eine strichpunktierte Linie symbolisiert.

Die Besäumschere 38 dient zu dem Zweck, das bandförmige Material 11 an entweder einer Bandkante davon, oder wahlweise an beiden Bandkanten (d.h. am linken und rechten Seitenrand des bandförmigen Materials 11) zu besäumen, d.h. dort durch ein Schneiden schmaler zu machen und dadurch die Breite des bandförmigen Materials 11 senkrecht zur Transportrichtung T zu vermindern. Die Besäumschere 38 wird im Betrieb der Vakuumbeschichtungsanlage 10 und bei einer entsprechenden Bewegung des bandförmigen Materials 11 entlang der Förderstrecke 12 dann betätigt, wenn durch den Positionssensor 36 erkannt wird, dass eine Breite des bandförmigen Materials 11 von einem vorbestimmten Sollwert abweicht und z.B. infolge einer Breitung zu groß ist. Durch das Besäumen wird erreicht, dass das bandförmige Material 11 in dem Bereich stromaufwärts der Einlaufschleuse 20, und damit vor dem Einlaufen hinein in die Beschichtungskammer 14, eine gleichbleibende Breite über dessen Länge erhält, wobei diese Breite auch optimal an die Breite der Einlaufschleuse 20 angepasst ist.

Nach einer weiteren (nicht gezeigten) Ausführungsform der Erfindung kann eine Streck-/Biegerichteinrichtung ebenfalls Bestandteil der Planheitsoptimierungseinrichtung 39 sein kann, ergänzend oder alternativ zu der genannten Dressiergerüsteinrichtung 40. Durch die Bezeichnung "K" und das zugeordnete gestrichelte Rechteck in Fig. 1 ist vereinfacht symbolisiert, dass die Planheitsoptimierungseinrichtung 39 auch als eine Kompakteinheit ausgebildet sein kann, die sowohl eine Dressiergerüsteinrichtung 40 als auch eine Streck-/Biegerichteinrichtung umfasst. Mittels der Streck-/Biegerichteinrichtung und einer Anstellung von deren Walzen können die Planheit des bandförmigen Materials 11 an dessen Oberflächen weiter verbessert werden und ggf. auch eine Bandverlängerung, d.h. eine Längung des bandförmigen Materials 11 in dessen Längsrichtung erzielt werden.

Durch ein Hindurchführen des bandförmigen Materials 11 durch die Beschichtungskammer 14 wird zumindest auf eine Oberfläche des bandförmigen Materials 11, vorzugsweise auf beide Oberflächen davon, eine Beschichtung aufgebracht, z.B. eine Zinkschicht. Dieses Beschichten kann innerhalb des Beschichtungsteil 26 nach dem Prinzip der PVD erfolgen. Nachdem zumindest eine Oberfläche des bandförmigen Materials 11 mit einer Beschichtung, z.B. mit einer Zinkschicht, versehen worden sind, wird das bandförmige Material 11 dann wie erläutert von der zweiten Haspeleinrichtung 12 wieder aufgewickelt.

Somit gelingt mit der vorliegenden Erfindung das Aufbringen einer Beschichtung auf eine bzw. die Oberfläche(n) des bandförmigen Materials 11 bei nur geringen Temperaturen, ohne dass die Materialeigenschaften des bandförmigen Materials 11 verändert bzw. beeinträchtigt werden. Dies ist insbesondere dann von Vorteil, wenn es sich bei dem bandförmigen Material um ein Stahlband insbesondere in Form von Warmband handelt, welches einen Gefügeanteil von mindestens 10% Martensit aufweist.

### Bezugszeichenliste

- 10: Vakuumbeschichtungsanlage
- 11: bandförmiges Material
- 12: Förderstrecke
- 14: Beschichtungskammer
- 16: Einlassbereich
- 18: Auslassbereich
- 20: Einlaufschleuse
- 22: Auslaufschleuse
- 24: Bandlagenregeleinrichtung
- 24.2: Bandlagenregeleinrichtung
- 24.3: Bandlagenregeleinrichtung
- 24.4: Bandlagenregeleinrichtung
- 26: Beschichtungsteil
- 28: Reinigungsteil
- 29: Lager/ Gehäuse
- 30: Stellglied
- 31: Kontaktrolle(n)
- 32: Druckgeber
- 33: Weggeber
- 34: Steuerungseinrichtung
- 35: Führungslineal(e)
- 36: Positionssensor
- 38: Besäumschere
- 39: Planheitsoptimierungseinrichtung
- 40: Dressiergerüsteinrichtung
- 42: chemische Reinigungseinrichtung
- 44: Speicher
- 46: erste Haspeleinrichtung (Einlauf)
- 48: zweite Haspeleinrichtung (Auslauf)
- 50: Steuerrolle
- 52: Steuerrolle
- A: Längsachse (einer Steuerrolle 50, 52)
- K: Kompakteinheit
- L: Spule(n)
- T: Transportrichtung (für das bandförmige Material 11)

## Patentansprüche

1. Vakuumbeschichtungsanlage (10) zum Beschichten eines bandförmigen Materials (11) aus Metall, umfassend
eine Förderstrecke (12) mit Transportmitteln insbesondere in Form von Walzen, auf denen das bandförmige Material (11) in einer Transportrichtung (T) bewegbar ist, wobei die Transportmittel der Förderstrecke (12) derart ausgebildet sind, dass darauf das bandförmige Material aus Metall (11) mit seiner Breitenerstreckung in horizontaler Ausrichtung in der Transportrichtung (T) bewegbar ist,
eine Beschichtungskammer (14), in der Vakuum erzeugbar ist, wobei die Beschichtungskammer (14) einen Einlassbereich (16) und einen Auslassbereich (18) aufweist und dadurch von dem bandförmigen Material (11) entlang bzw. auf der Förderstrecke (12) in der Transportrichtung (T) durchlaufbar ist,
eine Einlaufschleuse (20), die im Einlassbereich (16) der Beschichtungskammer (14) vorgesehen ist,
eine Auslaufschleuse (22), die im Auslassbereich (18) der Beschichtungskammer (14) vorgesehen ist, und
zumindest eine Bandlagenregeleinrichtung, mit der eine Position des bandförmigen Materials (11) einstellbar ist,
**dadurch gekennzeichnet,**
**dass** mit der Bandlagenregeleinrichtung (24) eine Position des bandförmigen Materials (11) in Bezug auf eine Mitte (12_{M}) der Förderstrecke (12) ausrichtbar ist, und **dass** die Bandlagenregeleinrichtung (24) innerhalb der Beschichtungskammer (14) angeordnet ist.

2. Vakuumbeschichtungsanlage (10) nach Anspruch 1, **dadurch gekennzeichnet, dass** eine weitere Bandlagenregeleinrichtung (24.2) - in Transportrichtung (T) des bandförmigen Materials (11) gesehen - stromaufwärts der Einlaufschleuse (20) angeordnet ist.

3. Vakuumbeschichtungsanlage (10) zum Beschichten eines bandförmigen Materials (11) aus Metall, umfassend
eine Förderstrecke (12) mit Transportmitteln insbesondere in Form von Rollen, auf denen das bandförmige Material (11) in einer Transportrichtung (T) bewegbar ist, wobei die Transportmittel der Förderstrecke (12) derart ausgebildet sind, dass darauf das bandförmige Material aus Metall (11) mit seiner Breitenerstreckung in horizontaler Ausrichtung in der Transportrichtung (T) bewegbar ist,
eine Beschichtungskammer (14), in der Vakuum erzeugbar ist, wobei die Beschichtungskammer (14) einen Einlassbereich (16) und einen Auslassbereich (18) aufweist und dadurch von dem bandförmigen Material (11) entlang bzw. auf der Förderstrecke (12) in der Transportrichtung (T) durchlaufbar ist,
eine Einlaufschleuse (20), die im Einlassbereich (16) der Beschichtungskammer (14) vorgesehen ist,
eine Auslaufschleuse (22), die im Auslassbereich (18) der Beschichtungskammer (14) vorgesehen ist, und
zumindest eine Bandlagenregeleinrichtung, mit der eine Position des bandförmigen Materials (11) einstellbar ist,
**dadurch gekennzeichnet,**
**dass** mit der Bandlagenregeleinrichtung eine Position des bandförmigen Materials (11) in Bezug auf eine Mitte (12_{M}) der Förderstrecke (12) ausrichtbar ist, und
**dass** die Bandlagenregeleinrichtung (24.2) - in Transportrichtung (T) des bandförmigen Materials (11) gesehen - stromaufwärts der Einlaufschleuse (20) angeordnet ist.

4. Vakuumbeschichtungsanlage (10) nach Anspruch 3, **dadurch gekennzeichnet, dass** eine weitere Bandlagenregeleinrichtung (24, 24.3, 24.4) vorgesehen ist, die innerhalb der Beschichtungskammer (14) angeordnet ist.

5. Vakuumbeschichtungsanlage (10) nach Anspruch 1 oder 4, **dadurch gekennzeichnet, dass** die Bandlagenregeleinrichtung (24) innerhalb der Beschichtungskammer (14) jeweils beabstandet zur Einlaufschleuse (20) und zur Auslaufschleuse (22) angeordnet ist.

6. Vakuumbeschichtungsanlage (10) nach einem der vorhergehenden Ansprüche, **dadurch gekennzeichnet, dass** die Beschichtungskammer (14) mehrteilig ausgebildet ist und einen Beschichtungsteil (26) und einen Reinigungsteil (28) aufweist, wobei der Reinigungsteil (28) an den Beschichtungsteil (26) angrenzt und - in Transportrichtung (T) des bandförmigen Materials (11) gesehen - stromaufwärts des Beschichtungsteils angeordnet ist, wobei die Bandlagenregeleinrichtung (24) zumindest in dem Beschichtungsteil (26) und/oder in dem Reinigungsteil (28) und/oder in einem Bereich der Beschichtungskammer (14) zwischen dem Beschichtungsteil (26) und dem Reinigungsteil (28) vorgesehen ist.

7. Vakuumbeschichtungsanlage (10) nach Anspruch 6, **dadurch gekennzeichnet, dass** in der Beschichtungskammer (14) mehrere Bandlagenregelungseinrichtungen (24, 24.3, 24.4) vorgesehen sind, wobei eine Bandlagenregelungseinrichtung jeweils in dem Beschichtungsteil (26), in dem Reinigungsteil (28) und/oder in dem Bereich der Beschichtungskammer (14) zwischen dem Beschichtungsteil (26) und dem Reinigungsteil (28) angeordnet ist.

8. Vakuumbeschichtungsanlage (10) nach einem der Ansprüche 1 bis 4 oder nach einem der Ansprüche 5 bis 7, **dadurch gekennzeichnet, dass** eine weitere Bandlagenregeleinrichtung (24.3) im Bereich der Einlaufschleuse (20) angeordnet ist.

9. Vakuumbeschichtungsanlage (10) nach einem der Ansprüche 1 bis 4 oder nach einem der Ansprüche 5 bis 8, **dadurch gekennzeichnet, dass** eine Bandlagenregeleinrichtung (24.3) im Bereich der Auslaufschleuse (22) angeordnet ist.

10. Vakuumbeschichtungsanlage (10) nach einem der vorhergehenden Ansprüche, **dadurch gekennzeichnet, dass** eine weitere Bandlagenregeleinrichtung (24.3) - in Transportrichtung (T) des bandförmigen Materials (11) gesehen - stromabwärts der Auslaufschleuse (22) angeordnet ist.

11. Vakuumbeschichtungsanlage (10) nach einem der vorhergehenden Ansprüche, **dadurch gekennzeichnet, dass** eine Bandlagenregeleinrichtung (24) Stellglieder (30) aufweist, die von beiden Seiten her an die Bandkanten des bandförmigen Materials (11) anstellbar sind, um damit eine Bandmitte des bandförmigen Materials (11) in Übereinstimmung mit einer Mitte (12_{M}) der Förderstrecke (12) zu bringen, vorzugsweise, dass die Stellglieder (30) drehbar gelagerte Kontaktrollen (31) aufweisen, weiter vorzugsweise, dass die Stellglieder (30)/Kontaktrollen (31) mit Linear-Stellelementen in Wirkverbindung stehen, die eine Anstellung an das bandförmige Material (11) quer zu dessen Transportrichtung (T) gewährleisten.

12. Vakuumbeschichtungsanlage (10) nach einem der vorhergehenden Ansprüche, **dadurch gekennzeichnet, dass** eine Bandlagenregeleinrichtung (24) Magnetelemente zur Erzeugung von Magnetfeldern umfasst, mittels derer eine Wechselwirkung mit einem bandförmigen Material (11) bestehend aus Stahl erzeugbar ist, um damit eine Bandmitte des bandförmigen Materials (11) in Übereinstimmung mit einer Mitte (12_{M}) der Förderstrecke (12) zu bringen.

13. Vakuumbeschichtungsanlage (10) nach Anspruch 12, **dadurch gekennzeichnet, dass** die Magnetelemente aus Permanentmagneten gebildet sind.

14. Vakuumbeschichtungsanlage (10) nach Anspruch 12 oder 13, **dadurch gekennzeichnet, dass** die Magnetelemente aus bestrombaren Spulen (L) gebildet sind.

15. Vakuumbeschichtungsanlage (10) nach einem der vorhergehenden Ansprüche, **dadurch gekennzeichnet, dass** zumindest ein Positionssensor (36) vorgesehen ist, mit dem eine Position des bandförmigen Materials (11) auf der Förderstrecke (12) bestimmbar ist, vorzugsweise, dass ein Positionssensor (36) innerhalb der Beschichtungskammer (14) und/oder - in Transportrichtung (T) des bandförmigen Materials (11) gesehen - stromaufwärts der Beschichtungskammer (14) angeordnet ist.

16. Vakuumbeschichtungsanlage (10) nach einem der vorhergehenden Ansprüche, **dadurch gekennzeichnet, dass** eine Steuerungseinrichtung (34) vorgesehen ist, wobei in Abhängigkeit von den Signalen des Positionssensors (36) eine Bandlagenregeleinrichtung (24, 24.2, 24.3, 24.4, 24.5) ansteuerbar ist und/oder die Bandlagenregeleinrichtungen (24, 24.2, 24.3, 24.4, 24.5), die in den verschiedenen Bereichen der Vakuumbeschichtungsanlage (10) angeordnet sind, miteinander synchronisierbar sind.

17. Verfahren zum Beschichten eines bandförmigen Materials (11) aus Metall, bei dem das bandförmige Material (11) mit seiner Breitenerstreckung in horizontaler Ausrichtung über eine Förderstrecke (12) in einer Transportrichtung (T) bewegt und innerhalb einer Beschichtungskammer (14), in der ein Vakuum angelegt ist, vakuumbeschichtet wird, wobei eine Position des bandförmigen Materials (11) durch eine Bandlagenregeleinrichtung (24) eingestellt wird,
**dadurch gekennzeichnet,**
**dass** das bandförmige Material aus Metall (11) mit seiner Bandmitte durch die Bandlagenregeleinrichtung (24) in Bezug auf eine Mitte (12_{M}) der Förderstrecke (12) ausgerichtet wird, wobei die Bandlagenregeleinrichtung (24) innerhalb der Beschichtungskammer (14) angeordnet ist.

18. Verfahren zum Beschichten eines bandförmigen Materials (11) aus Metall, bei dem das bandförmige Material (11) mit seiner Breitenerstreckung in horizontaler Ausrichtung über eine Förderstrecke (12) in einer Transportrichtung (T) bewegt und innerhalb einer Beschichtungskammer (14), in der ein Vakuum angelegt ist, vakuumbeschichtet wird, wobei eine Position des bandförmigen Materials (11) durch eine Bandlagenregeleinrichtung (24) eingestellt wird,
**dadurch gekennzeichnet,**
**dass** das bandförmige Material aus Metall (11) mit seiner Bandmitte durch die Bandlagenregeleinrichtung (24) in Bezug auf eine Mitte (12_{M}) der Förderstrecke (12) ausgerichtet wird, wobei die Bandlagenregeleinrichtung (24) - in Transportrichtung (T) des bandförmigen Materials (11) gesehen - stromaufwärts der Beschichtungskammer (14) und außerhalb davon angeordnet ist.

## Claims

1. Vacuum-coating system (10) for coating a band-type material (11) of metal, comprising
a conveying section (12) with transport means, particularly in the form of rollers, on which the band-type material (11) is movable in a transport direction (T), wherein the transport means of the conveying section (12) are constructed such a way that the band-type material (11) of metal is movable thereon with its width dimension in horizontal alignment in the transport direction (T),
a coating chamber (14), in which a vacuum can be generated, wherein the coating chamber (14) has an inlet region (16) and an outlet region (18) and thereby can be traversed by the band-type material along or on the conveying section (12) in the transport direction (T),
an entry lock (20), which is provided in the inlet region (16) of the coating chamber (14),
an exit lock (22), which is provided in the outlet region (18) of the coating chamber (14) and
at least one band position regulating device by which a position of the band-type material can be adjusted,
**characterised in that**
a position of the band-type material (11) can be aligned with respect to a centre (12_{M}) of the conveying section (12) by the band position regulating device (24) and
the band position regulating device (24) is arranged within the coating chamber (14).

2. Vacuum-coating system (10) according to claim 1, **characterised in that** a further band position regulating device (24.2) is arranged upstream of the entry lock (24) as seen in the transport direction (T) of the band-type material (11).

3. Vacuum-coating system (10) for coating a band-type material of metal (11), comprising
a conveying section (12) with transport means, particularly in the form of rollers, on which the band-type material (11) is movable in a transport direction (T), wherein the transport means of the conveying section (12) are constructed in such a way that the band-type material (11) of metal is movable thereon with its width dimension in horizontal alignment in the transport direction (T),
a coating chamber (14), in which a vacuum can be generated, wherein the coating chamber (14) has an inlet region (16) and an outlet region (18) and thereby can be traversed by the band-type material (11) along or on the conveying section (12) in the transport direction (T),
an entry lock (20), which is provided in the inlet region (16) of the coating chamber (14),
an exit lock (22), which is provided in the outlet region (18) of the coating chamber (14), and
at least one band position regulating device, by which a position of the band-type material (11) can be adjusted,
**characterised in that**
a position of the band-type material (11) can be aligned with respect to a centre (12_{M}) of the conveying section (12) by the band position regulating device and
the band position regulating device is arranged upstream of the entry lock (20) as seen in the transport direction (T) of the band-type material (11).

4. Vacuum-coating system (10) according to claim 3, **characterised in that** a further band position regulating device (24, 24.3, 24.4) is provided, which is arranged within the coating chamber (14).

5. Vacuum-coating system (10) according to claim 1 or 4, **characterised in that** the band position regulating device (24) is arranged within the coating chamber (14) at a spacing from the entry lock (20) and from the exit lock (22), respectively.

6. Vacuum-coating system (10) according to any one of the preceding claims, **characterised in that** the coating chamber (14) is of multi-part construction and has a coating part (26) and a cleaning part (28), wherein the cleaning part (28) is adjacent the coating part (26) and is arranged upstream of the coating part as seen in the transport direction (T) of the band-type material, wherein the band position regulating device (24) is provided at least in the coating part (26) and/or in the cleaning part (28) and/or in a region of the coating chamber (14) between the coating part (26) and the cleaning part (28).

7. Vacuum-coating system (10) according to claim 6, **characterised in that** several band position regulating devices (24, 24.3, 24.4) are provided in the coating chamber (14), wherein a respective band position regulating device is arranged in each of the coating part (26), the cleaning part (28) and/or the region of the coating chamber (14) between the coating part (26) and the cleaning part (28).

8. Vacuum-coating system (10) according to any one of claims 1 to 4 or any one of claims 5 to 7, **characterised in that** a further band position regulating device (24.3) is arranged in the region of the entry lock (20).

9. Vacuum-coating system (10) according to any one of claims 1 to 4 or any one of claims 5 to 8, **characterised in that** a band position regulating device (24.3) is arranged in the region of the exit lock (22).

10. Vacuum-coating system (10) according to any one of the preceding claims, **characterised in that** a further band position regulating device (24.3) is arranged downstream of the exit lock (22) as seen in the transport direction (T) of the band-type material (11).

11. Vacuum-coating system (10) according to any one of the preceding claims, **characterised in that** a band position regulating device (24) comprises actuators (30), which can be positioned at the band edges of the band-type material (11) from both sides in order to bring a band centre of the band-type material (11) into correspondence with a centre (12_{M}) of the conveying section (12), preferably **in that** the actuators (30) have rotatably mounted contact rollers (31), more preferably **in that** the actuators (30) / contact rollers (31) are operatively connected with linear adjusting elements which ensure placement at the band-type material (11) transversely to the transport direction (T) thereof.

12. Vacuum-coating system (10) according to any one of the preceding claims, **characterised in that** a band position regulating device (24) comprises magnet elements for generating magnetic fields, by which an interaction with a band-type material (11) consisting of steel can be produced in order to bring a band centre of the band-type material (11) into correspondence with a centre (12_{M}) of the conveying section (12).

13. Vacuum-coating system (10) according to claim 12 or 13, **characterised in that** the magnet elements are formed from permanent magnets.

14. Vacuum-coating system (10) according to claim 12 or 13, **characterised in that** the magnet elements are formed from energisable coils.

15. Vacuum-coating system (10) according to any one of the preceding claims, **characterised in that** at least one position sensor (36) is provided, by which a position of the band-type material (11) on the conveying section (12) can be determined, preferably **in that** a position sensor (36) is arranged within the coating chamber (14) and/or upstream of the coating chamber (14) as seen in the transport direction (T) of the band-type material (11).

16. Vacuum-coating system (10) according to any one of the preceding claims, **characterised in that** a control unit (34) is provided, wherein a band position regulating device (24, 24.2, 24.3, 24.4, 24.5) can be activated and/or the band position regulating devices (24, 24.2, 24.3, 24.4, 24.5), which are arranged in the various regions of the vacuum-coating system (10), can be synchronised with one another as a function of the signals of the position sensor (36).

17. Method of coating a band-type material (11) of metal, in which the band-type material (11) is moved, with its width dimension in horizontal orientation, via a conveying section (12), in a transport direction (T) and is vacuum-coated within a coating chamber in which a vacuum is applied, wherein a position of the band-type material (11) is adjusted by a band position regulating device (24), **characterised in that** the band-type material (11) of metal is aligned by its band centre with respect to a centre (12_{M}) of the conveying section (12) by the band position regulating device (24), wherein the band position regulating device (24) is arranged within the coating chamber (14).

18. Method of coating a band-type material (11) of metal, in which the band-type material (11) is moved, with its width dimension in horizontal orientation, via a conveying section (12), in a transport direction (T) and is vacuum-coated within a coating chamber in which a vacuum is applied, wherein a position of the band-type material (11) is adjusted by a band position regulating device (24), **characterised in that** the band-type material (11) of metal is aligned by its band centre with respect to a centre (12_{M}) of the conveying section (12) by the band position regulating device (24), wherein the band position regulating device (24) is arranged upstream of the coating chamber (14) as seen in transport direction (T) of the band-type material (11) and outside the chamber.

## Revendications

1. Installation de revêtement sous vide (10) pour le revêtement d'un matériau sous forme de bande (11) de métal comprenant
une section de transport (12) avec des moyens de transport, notamment sous forme de rouleaux, sur lesquels le matériau sous forme de bande (11) de métal peut être déplacé dans une direction de transport (T), les moyens de transport de la section de transport (12) étant conçus de sorte que le matériau métallique sous forme de bande (11) de métal puisse y être déplacé avec l'extension de sa largeur en alignement horizontal dans la direction de transport (T),
une chambre de revêtement (14) à l'intérieur de laquelle du vide peut être généré, la chambre de revêtement (14) étant pourvue d'une zone d'entrée (16) et d'une zone de sortie (18), pouvant ainsi être traversée par le matériau sous forme de bande (11) tout au long ou sur la section de transport (12) dans la direction de transport (T),
un sas d'entrée (20) prévu dans la zone d'entrée (16) de la chambre de revêtement (14),
un sas de sortie (22) prévu dans la zone de sortie (18) de la chambre de revêtement (14), et
au minimum un dispositif de commande de la position de la bande, avec lequel la position du matériau sous forme de bande peut être ajustée (11),
**caractérisée**
**en ce que** le dispositif de commande de la position de la bande (24) peut être utilisé pour aligner la position du matériau sous forme de bande (11) par rapport à un centre (12_{M}) de la section de transport (12), et
**en ce que** le dispositif de commande de la position de la bande (24) est disposé à l'intérieur de la chambre de revêtement (14).

2. Installation de revêtement sous vide (10) selon la revendication 1, **caractérisée en ce qu'**un autre dispositif de commande de la position de la bande (24.2) - regardé dans la direction du transport (T) du matériau sous forme de bande (11) - est disposé en amont du sas d'entrée (20).

3. Installation de revêtement sous vide (10) pour le revêtement d'un matériau sous forme de bande (11) de métal comprenant
une section de transport (12) avec des moyens de transport, notamment sous forme de rouleaux, sur lesquels le matériau sous forme de bande (11) de métal peut être déplacé dans une direction de transport (T), les moyens de transport de la section de transport (12) étant conçus de sorte que le matériau métallique sous forme de bande (11) de métal peut y être déplacé avec l'extension de sa largeur en alignement horizontal dans la direction de transport (T),
une chambre de revêtement (14) à l'intérieur de laquelle du vide peut être généré, la chambre de revêtement (14) étant pourvue d'une zone d'entrée (16) et d'une zone de sortie (18), pouvant ainsi être traversée par le matériau sous forme de bande (11) tout au long ou sur la section de transport (12) dans la direction du transport (T),
un sas d'alimentation (20) prévu dans la zone d'entrée (16) de la chambre de revêtement (14),
un sas de sortie (22) prévu dans la zone de sortie (18) de la chambre de revêtement (14), et
au minimum un dispositif de commande de la position de la bande, avec lequel la position du matériau sous forme de bande peut être ajustée (11),
**caractérisée**
**en ce que** le dispositif de commande de la position de la bande peut être utilisé pour aligner la position du matériau sous forme de bande (11) par rapport à un centre (12_{M}) de la section de transport (12), et
**en ce que** le dispositif de commande de la position de la bande (24.2) - tel qu'il est vu dans la direction de transport (T) du matériau sous forme de bande (11) - est disposé en amont du sas d'entrée (20).

4. Installation de revêtement sous vide (10) selon la revendication 3, **caractérisée en ce qu'**un autre dispositif de commande de la position de la bande (24, 24.3, 24.4) est prévu, lequel est disposé à l'intérieur de la chambre de revêtement (14).

5. Installation de revêtement sous vide (10) selon la revendication 1 ou 4, **caractérisée en ce que** le dispositif de commande de la position de la bande (24) est disposé à l'intérieur de la chambre de revêtement (14) à distance du sas d'entrée (20) et du sas de sortie (22).

6. Installation de revêtement sous vide (10) selon l'une des revendications précédentes, **caractérisée en ce que** la chambre de revêtement (14) est constituée de plusieurs parties et comprend un élément de revêtement (26) et un élément de nettoyage (28), où l'élément de nettoyage (28) est adjacent à l'élément de revêtement (26) et - regardé dans la direction de transport (T) du matériau sous forme de bande (11) - est disposé en amont de l'élément de revêtement, où le dispositif de commande de la position de la bande (24) est prévu au minimum dans l'élément de revêtement (26) et/ou l'élément de nettoyage (28) et/ou dans une zone de la chambre de revêtement (14) entre l'élément de revêtement (26) et l'élément de nettoyage (28).

7. Installation de revêtement sous vide (10) selon la revendication 6, **caractérisée en ce que** plusieurs dispositifs de commande de la position de bande (24, 24.3, 24.4) sont prévus dans la chambre de revêtement (14), un dispositif de commande de la position de la bande étant disposé en chaque cas dans l'élément de revêtement (26), dans l'élément de nettoyage (28) et/ou dans la zone de la chambre de revêtement (14) entre l'élément de revêtement (26) et l'élément de nettoyage (28).

8. Installation de revêtement sous vide (10) selon l'une des revendications 1 à 4 ou selon l'une des revendications 5 à 7, **caractérisée en ce qu'**un autre dispositif de commande de la position de la bande (24.3) est disposé dans la zone du sas d'alimentation (20).

9. Installation de revêtement sous vide (10) selon l'une des revendications 1 à 4 ou selon l'une des revendications 5 à 8, **caractérisée en ce qu'**un dispositif de commande de la position de la bande (24.3) est disposé dans la zone du sas de sortie (22).

10. Installation de revêtement sous vide (10) selon une des revendications précédentes, **caractérisée en ce qu'**un autre dispositif de commande de la position de la bande (24.3) - regardé dans la direction du transport (T) du matériau sous forme de bande (11) - est disposé en amont du sas de sortie (22).

11. Installation de revêtement sous vide (10) selon l'une des revendications précédentes, **caractérisée en ce qu'**un dispositif de commande de la position de la bande (24) comprend des actionneurs (30) réglables de deux côtés sur les bords de la bande de matériau sous forme de bande (11) de manière amener le centre de la bande de matériau sous forme de bande (11) en correspondance avec le centre (12M) de la section de transport (12), de préférence avec les actionneurs (30) comprenant des rouleaux de contact (31) montés en mode rotatif, ainsi que, de préférence avec les actionneurs (30) / rouleaux de contact (31) reliés de manière opérationnelle avec des éléments de réglage linéaire qui assurent le réglage du matériau sous forme de bande (11) transversalement au sens de transport (T) de celui-ci.

12. Installation de revêtement sous vide (10) selon l'une des revendications précédentes, **caractérisée en ce qu'**un dispositif de commande de la position de la bande (24) comprend des éléments magnétiques pour générer des champs magnétiques au moyen desquels il est possible de générer une interaction avec un matériau sous forme de bande (11) en acier, afin d'amener un centre de la bande de matériau sous forme de bande (11) en correspondance avec un centre (12_{M}) de la section de transport (12).

13. Installation de revêtement sous vide (10) selon la revendication 12, **caractérisée en ce que** les éléments magnétiques sont formés d'aimants permanents.

14. Installation de revêtement sous vide (10) selon la revendication 12 ou 13, **caractérisée en ce que** les éléments magnétiques sont formés de bobines (L) pouvant être alimentées en courant.

15. Installation de revêtement sous vide (10) selon l'une des revendications précédentes, **caractérisée en ce qu'**au moins un capteur de position (36) est prévu, à l'aide duquel la position du matériau sous forme de bande (11) sur la section de transport (12) peut être déterminée, de préférence par le fait qu'un capteur de position (36) est disposé à l'intérieur de la chambre de revêtement (14) et/ou - regardé dans la direction du transport (T) du matériau sous forme de bande (11) - en amont de la chambre de revêtement ( 14).

16. Installation de revêtement sous vide (10) selon l'une des revendications précédentes, **caractérisée en ce qu'**un dispositif de commande (34) est prévu, où un dispositif de commande de la position de la bande (24, 24.2, 24.3, 24.4, 24.5) peut être commandé en fonction des signaux du capteur de position (36) et/ou les dispositifs de commande de la position de la bande (24, 24.2, 24.3, 24.4, 24.5), qui sont disposés dans de différentes zones de l'installation de revêtement sous vide (10), peuvent être synchronisés les uns avec les autres.

17. Procédé de revêtement d'un matériau sous forme de bande (11) en métal, où le matériau sous forme de bande (11) est déplacé avec l'extension de sa largeur en alignement horizontal sur une section de transport (12) dans une direction de transport (T) et reçoit un revêtement sous vide à l'intérieur d'une chambre de revêtement (14) dans laquelle du vide est appliqué, une position du matériau sous forme de bande (11) étant déterminée par un dispositif de commande de la position de la bande (24),
**caractérisé en ce que**
le matériau métallique sous forme de bande (11) est aligné avec son centre de bande par le dispositif de commande de la position de la bande (24) par rapport à un centre (12_{M}) de la section de transport (12), où le dispositif de commande de la position de la bande (24) est disposé à l'intérieur de la chambre de revêtement (14).

18. Procédé de revêtement d'un matériau sous forme de bande (11) en métal, où le matériau sous forme de bande (11) est déplacé avec l'extension de sa largeur en direction horizontale sur une section de transport (12) dans une direction de transport (T) et reçoit un revêtement sous vide à l'intérieur d'une chambre de revêtement (14) dans laquelle du vide est appliqué, la position du matériau sous forme de bande (11) étant déterminée par un dispositif de commande de la position de la bande (24),
**caractérisé**
**en ce que** le matériau sous forme de bande de métal (11) est aligné à son centre de bande par le dispositif de commande de la position de la bande (24) par rapport à un centre (12_{M}) de la section de transport (12), le dispositif de commande de la position de la bande (24) - regardé dans la direction de transport (T) du matériau en bande (11) - étant disposé en amont de la chambre de revêtement (14) et à l'extérieur de celle-ci.
